# EUROPÄISCHE PATENTSCHRIFT

(11) **EP 2 195 859 B1**
(45) Veröffentlichungstag und Bekanntmachung des Hinweises auf die Patenterteilung: **16.03.2011**
(21) Anmeldenummer: 08784787.7
(22) Anmeldetag: 15.07.2008
(51) Int. Cl.: H01L 31/055, H01L 31/052

(54) **Solarelement mit gesteigerter Effizienz und Verfahren zur Effizienzsteigerung**
Solar cell with increased efficiency and method for increasing the efficiency
Élément solaire à efficacité accrue et procédé pour augmenter son efficacité

(30) Priorität: 24.09.2007 DE 102007045546
(43) Veröffentlichungstag der Anmeldung: 16.06.2010
(73) Patentinhaber: Fraunhofer-Gesellschaft zur Förderung der angewandten Forschung e.V., 80686 München (DE); Albert-Ludwigs-Universität Freiburg, 79085 Freiburg (DE)
(72) Erfinder: GOLDSCHMIDT, Jan Christoph, 79100 Freiburg (DE); LÖPER, Philipp, 79100 Freiburg (DE); PETERS, Marius, 79110 Freiburg (DE)
(74) Vertreter: Pfenning, Meinig & Partner GbR
(86) Internationale Anmeldenummer: PCT/EP2008/005779
(87) Internationale Veröffentlichungsnummer: WO 2009/039906

(56) Entgegenhaltungen:
- WO-A-03/079457
- GB-A- 1 562 994
- STRUMPEL ET AL: "Modifying the solar spectrum to enhance silicon solar cell efficiency-An overview of available materials" SOLAR ENERGY MATERIALS AND SOLAR CELLS, ELSEVIER SCIENCE PUBLISHERS, AMSTERDAM, NL, Bd. 91, Nr. 4, 10. Dezember 2006 (2006-12-10), Seiten 238-249, XP005882124 ISSN: 0927-0248
- STRUMPEL C ET AL: "Enhancing Silicon Solar Cell Efficiency by Modifying the Solar Spectrum" PHOTOVOLTAIC ENERGY CONVERSION, CONFERENCE RECORD OF THE 2006 IEEE 4TH WORLD CONFERENCE ON, IEEE, PI, 1. Januar 2006 (2006-01-01), Seiten 87-90, XP031007244 ISBN: 978-1-4244-0016-4
- C. STRÜMPEL ET AL.: "Erbium-Doped Up-Converters on Silicon Solar Cells: Assessment of the Potential" PROCEEDINGS OF THE 20TH EUROPEAN PHOTOVOLTAIC SOLAR ENERGY CONF. 2005, 2005, Seiten 43-46, XP002543131
- A.SHALAV, B. S. RICHARDS, T. TRUPKE: "Application of Na YF4: Er3+ up-converting phosphors for enhanced near-infrared silicon solar cell responce" APPLIED PHYSICS LETTERS, Bd. 86, Nr. 1, 2005, Seite 13505, XP002543132
- TRUPKE T ET AL: "Improving solar cell efficiencies by up-conversion of sub-band-gap light" JOURNAL OF APPLIED PHYSICS, AMERICAN INSTITUTE OF PHYSICS. NEW YORK, US, Bd. 92, Nr. 7, 1. Oktober 2002 (2002-10-01), Seiten 4117-4122, XP012057396 ISSN: 0021-8979

## Beschreibung

Die vorliegende Erfindung betrifft ein Solarelement mit gesteigerter Effizienz sowie ein Verfahren zur Steigerung der Effizienz einer Solarzelle.

Mehr als 20 % der im Solarspektrum enthaltenen Energie gehen bei der Umwandlung der einfallenden Strahlung mittels Silicium-Solarzellen durch so genannte Sub-Bandgapverluste verloren. Damit bezeichnet man Verluste, die entstehen, weil die Energie eines einzelnen Photons nicht ausreicht, um ein frei bewegliches Elektron zu erzeugen. Sie treten auf, wenn die Energie eines Photons die so genannte Bandlückenenergie unterschreitet. Derartige Verluste treten bei allen Arten von Solarzellen auf. Ihre Höhe ist abhängig von der Bandlückenenergie des verwendeten Solarzellenmaterials. Die beschriebenen Verluste lassen sich reduzieren, indem mit so genannten hochkonvertierenden Materialien mehrere Photonen mit zu geringer Energie in ein Photon mit ausreichender Energie umgewandelt werden.

Hierbei treten die folgenden Probleme auf: Erstens ist der Absorptionsbereich der Hochkonverter recht schmal. Nur die wenigen Photonen in diesem Spektralbereich kommen überhaupt für die Hochkonversion in Frage.

Um mehr Photonen für die Hochkonversion nutzbar zu machen, kann eine Substanz mit speziellen lumineszenten Eigenschaften genutzt werden. Diese absorbiert im gesamten oder einem Teil des Spektralbereichs zwischen Bandlücke und Absorptionsbereich des Hochkonverters und emittiert Strahlung bei einer Wellenlänge, die von dem hochkonvertierenden Material zur Hochkonversion genutzt werden kann. Infrage kommende Stoffe mit entsprechenden lumineszenten Eigenschaften absorbieren allerdings auch in dem Spektralbereich, in dem die Hochkonverter das hochkonvertierte Licht abstrahlen. Dadurch erreicht nur ein geringer Teil der hochkonvertierten Strahlung die Solarzelle. Ohne weitere Maßnahmen geht also ein großer Teil der hochkonvertierten Strahlung durch unerwünschte Absorption verloren.

Ein weiteres Problem besteht darin, dass die Effizienz der Umwandlung zweier niederenergetischer Photonen in ein höher energetisches sehr gering ist. Die Hochkonversion ist ein nichtlinearer Prozess, da an ihm mehr als ein Photon beteiligt ist. Die Hochkonversionseffizienz steigt deshalb, zumindest bei niedrigen Intensitäten, linear mit der Flussdichte der prinzipiell vom Hochkonverter nutzbaren Photonen an (A. Shalav, B. S. Richards, T. Trupke et al., Appl. Phys. Lett. 86 (2005) 13505). Das Problem der sehr geringen Hochkonversionseffizienzen lässt sich also durch eine Konzentration des einfallenden Sonnenlichtes verringern. In T. Trupke, M. A. Green, P. Würfel, Journal of Applied Physics, 92, 71 (2002) wird die Möglichkeit der Konzentration mittels einer Linse erwähnt. Zur experimentellen Untersuchung der Hochkonversionseffekte werden meistens Laser mit hoher Intensität (im Vergleich zum Sonnenspektrum in dem entsprechenden Spektralbereich) benutzt.

Die Verbreiterung des für die Hochkonversion nutzbaren Spektralbereiches mit Fluoreszenzfarbstoffen wird in C. Strümpel, M. McCann, C. del Cañizo et al., Proceedings of the 20th EUPVSEC (2005), Barcelona, kurz beschrieben. Es werden aber keine konkreten Umsetzungen vorgeschlagen.

Aus Strumpel et al. "Modifying the solar spectrum to enhance silicon solar cell efficiency - An overview of available materials" Solar Energy Materials and Solar Cells, Elsevier Science Publishers, Amsterdam, NL, Bd. 91, Nr. 4, 10. Dezember 2006 (2006-12-10), Seiten 238-249, XP005882124, ISSN: 0927-0248 ist die Verwendung von lumineszenten Elementen und Hochkonvertern zur Steigerung der Effizienz von Solarzellen bekannt.

Es ist zunächst Aufgabe der vorliegenden Erfindung, den Verlust der hochkonvertierten Strahlung durch Absorption zu minimieren. Diese Aufgabe wird gelöst durch das Solarelement nach Anspruch 1 sowie das Verfahren nach Anspruch 16. Vorteilhafte Weiterbildungen der erfindungsgemäßen Solarzelle und des erfindungsgemäßen Verfahrens werden in den jeweiligen Unteransprüchen gegeben.

Der Erfindung liegt die Idee zugrunde, die Hochkonverter von den lumineszenten Elementen räumlich zu trennen und zwischen den Hochkonvertern und den lumineszenten Elementen erste selektiv reflektierende und/oder selektiv transmittierende Schichten oder Strukturen anzuordnen. Vorzugsweise reflektieren diese selektiv reflektierenden Strukturen elektromagnetische Strahlung mit Energien, die höher als die Band-Gap-Energie der Solarzelle sind. Elektromagnetische Strahlung, deren Frequenz zwischen der kleinsten vom Hochkonverter konvertierbaren Frequenz und der Band-Gap-Frequenz der Solarzelle liegt, sollte vorzugsweise von der selektiv reflektierenden Struktur transmittiert werden. Auf diese Weise trifft Strahlung mit einer Frequenz kleiner als der Band-Gap-Frequenz der Solarzelle auf die lumineszenten Elemente. Diese emittieren dann Strahlung mit Frequenzen, die vom Hochkonverter konvertiert werden können. Diese Strahlung durchläuft die selektiv reflektierende Schicht und trifft auf den Hochkonverter. Dieser konvertiert die einfallende Strahlung und emittiert Strahlung mit Frequenzen größer als der Band-Gap-Frequenz der Solarzelle. Da die selektiv reflektierende Schicht Strahlung mit Frequenzen größer als der Band-Gap-Energie reflektiert, kann die vom Hochkonverter emittierte Strahlung nicht zurück ins lumineszente Element gelangen und wird daher dort nicht absorbiert.

Erfindungsgemäß weist nun das Solarelement zumindest eine Solarzelle auf, die eine Band-Gap-Frequenz ν_{BG} hat. Darüber hinaus weist das erfindungsgemäße Solarelement zumindest ein lumineszentes Element auf, welches elektromagnetische Strahlung mit Frequenzen zwischen zwei Frequenzen ν_{LE1} und ν_{LE2} absorbiert und elektromagnetische Strahlung mit zumindest einer Frequenz ν_{LE3} emittiert. Die lumineszenten Elemente sind vorzugsweise so angeordnet, dass von einer Lichtquelle, wie zum Beispiel der Sonne, kommende Strahlung, welche wegen ihrer geringen Energie nicht in der Solarzelle absorbiert wird, durch diese hindurch auf die lumineszenten Elemente strahlt. Solarzellen und lumineszente Elemente sind also jeweils in Richtung des Strahlenganges einfallender Strahlung hintereinander angeordnet.

Das erfindungsgemäße Solarelement weist außerdem zumindest einen Hochkonverter auf, der elektromagnetische Strahlung mit Frequenzen zwischen zwei Frequenzen ν_{HK1} und ν_{HK2} absorbiert und Strahlung mit zumindest einer Frequenz ν_{HK3} emittiert. Dieser Hochkonverter ist so angeordnet, dass Licht, welches vom lumineszenten Element emittiert wird, auf den Hochkonverter fällt.

Erfindungsgemäß ist nun zwischen den lumineszenten Elementen und den Hochkonvertern zumindest eine erste selektiv reflektierende Schicht angeordnet, die einen Teil der auftreffenden elektromagnetischen Strahlung reflektiert und einen Teil dieser Strahlung transmittiert.

Die lumineszenten Elemente sind nun so gewählt, dass die kleinste von ihnen absorbierte Frequenz ν_{LE1} kleiner ist als die Band-Gap-Energie der Solarzelle ν_{BG}. Die von den lumineszenten Elementen emittierte Strahlung ν_{LE3} liegt erfindungsgemäß in dem Frequenzbereich, der vom Hochkonverter absorbiert werden kann, d. h. zwischen ν_{HK1} und ν_{HK2}. Der Hochkonverter emittiert dann Strahlung mit einer Frequenz ν_{HK3}, welche größer oder gleich der Band-Gap-Frequenz der Solarzelle ν_{BG} ist.

Trifft also Licht von einer Lichtquelle auf die Solarzelle, so wird der Anteil des Lichts, der eine Frequenz größer als die Band-Gap-Frequenz der Solarzelle hat, von der Solarzelle absorbiert, während jene Strahlung mit kleineren Frequenzen die Solarzelle durchläuft. Diese, die Solarzelle durchlaufende Strahlung, trifft nun auf die lumineszenten Elemente, die einen Teil dieser Strahlung absorbieren. Die lumineszenten Elemente strahlen dann Licht bzw. Strahlung mit zumindest einer bestimmten Frequenz oder in zumindest einem, vorzugsweise engen, Frequenzbereich ab. Diese emittierte Strahlung wird normalerweise ungerichtet abgegeben. Zumindest ein Teil dieser Strahlung trifft nun auf Hochkonverter, welche die Strahlung in Strahlung mit höherer Frequenz konvertieren. Da zwischen den lumineszenten Elementen und den Hochkonvertern die ersten selektiv reflektierenden Schichten angeordnet sind, kann einerseits die hochzukonvertierende Strahlung vom lumineszenten Element in den Hochkonverter treten, andererseits kann jedoch die hochkonvertierte Strahlung nicht ins lumineszente Element strahlen. Die hochkonvertierte Strahlung wird daher in Richtung der Solarzelle abgestrahlt und trifft dann zumindest teilweise auf die Solarzelle.

Erfindungswesentlich ist also, dass die lumineszenten Elemente und die Hochkonverter jeweils durch eine erste selektiv reflektierende Struktur getrennt nebeneinander angeordnet sind. Außerdem sind die Hochkonverter benachbart zu den Solarzellen angeordnet, so dass die hochkonvertierte Strahlung auf die Solarzelle treffen kann. Vorzugsweise sind die lumineszenten Elemente ebenfalls benachbart zur Solarzelle angeordnet, damit jene von der Solarzelle nicht absorbierte Strahlung durch diese hindurch auf die lumineszenten Elemente treffen kann.

Es ist bevorzugt, wenn die lumineszenten Elemente dort, wo sie nicht der Solarzelle, der ersten reflektierenden Schicht, dem Hochkonverter oder anderen Elementen benachbart angeordnet sind, von Spiegeln umgeben sind. Diese Spiegel können die entsprechenden Flächen der lumineszenten Elemente teilweise oder vollständig abdecken. Die Seitenfläche der lumineszenten Elemente sind vorzugsweise eben, so dass die Spiegel, welche ebenfalls eben sind, parallel zu diesen Seitenflächen angeordnet sind. Durch diese Spiegel wird erreicht, dass die Strahlung geeigneter Frequenz vollständig vom lumineszenten Element absorbiert wird und vom lumineszenten Element emittierte Strahlung vollständig in die Hochkonverter gelangt.

Wie bereits beschrieben, ist es vorteilhaft, wenn die erste reflektierende Struktur elektromagnetische Strahlung mit Frequenzen, die größer als die Band-Gap-Frequenz der Solarzelle ν_{BG} sind, reflektiert und elektromagnetische Strahlung mit Frequenzen zwischen der kleinsten hochkonvertierbaren Strahlung ν_{HK1} und der Band-Gap-Frequenz ν_{BG} transmittiert. Mindestens sollte die erste selektiv reflektierende Struktur elektromagnetische Strahlung mit Frequenzen zwischen ν_{HK1} und ν_{HK2} transmittieren. Vorteilhafterweise sollte ein möglichst großer Anteil des Lichts mit Frequenzen größer als ν_{BG} von der ersten selektiv reflektierenden Struktur reflektiert werden.

Besonders vorteilhaft ist es hierbei, wenn die ersten selektiv reflektierenden Strukturen elektromagnetische Strahlung mit Frequenzen, die zwischen ν_{HK2} und ν_{BG} liegen, transmittieren.

Grundsätzlich ist es nicht erforderlich, dass die genannten Bestandteile des Solarelementes direkt, d. h. formschlüssig, aneinander grenzen. Es ist jedoch, insbesondere für eine einfache Herstellung und eine geringe Baugröße, vorteilhaft, wenn zumindest einige oder alle der genannten Elemente unmittelbar aneinander grenzen, d. h. einander berühren. So kann das zumindest eine lumineszente Element unmittelbar angrenzend an eine erste selektiv reflektierende Struktur angeordnet sein und/oder zumindest eine erste selektiv reflektierende Struktur kann unmittelbar angrenzend an zumindest einen Hochkonverter angeordnet sein und/oder zumindest ein Hochkonverter kann unmittelbar angrenzend an eine Solarzelle angeordnet sein. Zwischen der Solarzelle und den lumineszenten Elementen kann ein Luftspalt bestehen, licht- oder strahlungsdurchlässige Materialien angeordnet sein oder die Solarzelle und die lumineszenten Elemente können einander berührend angeordnet sein.

Wie bereits geschildert steigt die Effizienz der Hochkonverter mit der Intensität der eingestrahlten Strahlung. Es ist deshalb für die vorliegende Erfindung vorteilhaft, wenn die Strahlung auf den Hochkonverter konzentriert werden kann. Erfindungsgemäß kann dies dadurch erreicht werden, dass die Summe aus jenem Teil der Oberfläche der Hochkonverter, der der Solarzelle zugewandt ist, plus die Teile der Oberfläche der lumineszenten Elemente, die der Solarzelle zugewandt sind, aber nicht von einem Hochkonverter bedeckt werden, größer ist als die Summe der Flächen zwischen lumineszenten Elementen und Hochkonvertern. Besonders vorteilhaft ist es, wenn die lumineszenten Elemente von reflektierenden Schichten oder Strukturen umgeben werden. Hierbei wird vorzugsweise auf den zur Solarzelle unmittelbar benachbarten Seiten des lumineszenten Elementes zumindeste eine zweite selektiv reflektierende Struktur angeordnet, die einen Teil der auf sie auftreffenden Strahlung reflektiert und einen Teil der auf sie auftreffenden Strahlung transmittiert. Diese zweite selektiv reflektierende Struktur ist also zwischen den lumineszenten Elementen und der Solarzelle angeordnet. An jenen Seiten der lumineszenten Elemente, welche weder der Solarzelle noch einem hochkonvertierenden Element zugewandt sind, sind vorzugsweise Spiegel angeordnet, welche zumindest jenes Licht reflektieren, welches Frequenzen zwischen der kleinsten vom lumineszenten Element absorbierbaren Frequenz bzw. der von lumineszenten Elementen emittierten Frequenz, je nachdem, welche kleiner ist, und der Band-Gap-Frequenz der Solarzelle hat.

Vorzugsweise reflektiert die zweite selektiv reflektierende Struktur elektromagnetische Strahlung mit der zumindest einen Frequenz ν_{LE3}, welche vom entsprechenden lumineszenten Element emittiert wird. Elektromagnetische Strahlung mit Frequenzen zwischen ν_{LE1} und ν_{LE2} wird transmittiert. Alternativ kann auch elektromagnetische Strahlung mit Frequenzen zwischen ν_{LE1} und ν_{BG} transmittiert und über ν_{BG} reflektiert werden, wobei jedoch jene Strahlung mit der zumindest einen Frequenz ν_{LE3}, die vom lumineszenten Element emittiert wird, reflektiert wird.

Es ist nun besonders bevorzugt, wenn die ersten reflektierenden Schichten die jeweiligen Grenzbereiche zwischen den lumineszenten Elementen und den entsprechenden benachbarten Hochkonvertern vollständig bedecken. Das bedeutet, dass von jedem lumineszenten Element jene dem entsprechenden Hochkonverter zugewandte Seite vollständig von der ersten selektiv reflektierenden Schicht bedeckt ist. Außerdem ist es besonders bevorzugt, wenn die zweite selektiv reflektierende Schicht jene Bereiche der Oberfläche der lumineszenten Elemente, welche der Solarzelle zugewandt sind und unmittelbar zur Solarzelle benachbart sind, vollständig bedeckt. Hierbei kommt es darauf an, dass jene Bereiche der lumineszenten Elemente von der zweiten selektiv reflektierenden Schicht bedeckt sind, welche über diese zweite selektiv reflektierende Schicht direkt, über im interessierenden Frequenzbereich vollständig transparente Zwischenschichten oder über Luft an die Solarzelle angrenzen. Dort, wo die lumineszenten Elemente an eine erste selektiv reflektierende Schicht bzw. einen Hochkonverter grenzen, ist keine zweite selektiv reflektierende Schicht angeordnet.

Die Aufgabe, die Strahlung auf die Hochkonverter zu konzentrieren, kann nun dadurch gelöst werden, dass jene Bereiche der lumineszenten Elemente, die der einfallenden Strahlung, d. h. der Solarzelle zugewandt sind, eine größere Fläche haben, als jene Bereiche, die den Hochkonvertern zugewandt sind. Auf diese Weise fällt die Strahlung auf einer großen Fläche in das lumineszente Element ein und verlässt dieses aber in Richtung des Hochkonverters nur über eine kleine Fläche. Alle anderen Oberflächen der lumineszenten Elemente als jene den Hochkonvertern zugewandten sind vorzugsweise durch Spiegel oder zweite selektiv reflektierende Strukturen begrenzt. Auf diese Weise wird eine Konzentration des vom lumineszenten Element emittierten Lichtes auf den Hochkonverter unterstützt.

Vorzugsweise ist an jeder Oberfläche der lumineszenten Elemente, an der keine selektiv reflektierende Schicht angeordnet ist, ein Spiegel angeordnet.

Das erfindungsgemäße Solarelement kann auf verschiedene Weise realisiert werden. Eine Möglichkeit besteht darin, Hochkonverter zwischen einem lumineszenten Element und der Solarzelle anzuordnen. Ist der Hochkonverter über die gesamte der Solarzelle zugewandte Fläche des lumineszenten Elementes zwischen der Solarzelle und dem lumineszenten Element angeordnet, so wird zwar kein Konzentrationseffekt erreicht, es wird jedoch das Problem der Absorption der konvertierten Strahlung gelöst. Die erste selektiv reflektierende Schicht ist hierbei zwischen dem Hochkonverter und dem lumineszenten Element angeordnet. Eine zweite selektiv reflektierende Schicht gibt es hier nicht.

Die Hochkonverter können jedoch auch nur einen Teil jener der Solarzelle zugewandten Fläche des lumineszenten Elementes bedecken. In diesem Falle ist die erste selektiv reflektierende Schicht zwischen dem Hochkonverter und dem lumineszenten Element angeordnet, während dort, wo das lumineszente Element zur Solarzelle benachbart ist, ohne dass dazwischen ein Hochkonverter angeordnet ist, vorzugsweise eine zweite selektiv reflektierende Schicht aufgebracht ist. In diesem Fall wird der oben beschriebene Konzentrationseffekt erreicht. Grundsätzlich kann ein Konzentrationseffekt erreicht werden, wenn die Summe aus all jenen Oberflächen der Hochkonverter, die der Solarzelle zugewandt sind, so dass aus ihnen austretendes Licht auf die Solarzelle fällt plus den Flächen der luminsezenten Elementen die der Solarzelle, aber nicht einem Hochkonverter zugewandt sind, größer ist als die Summe jener Flächenbereiche mit denen die lumineszenten Elemente den Hochkonvertern zugewandt sind, wo also die lumineszenten Elemente durch Hochkonverter abgedeckt werden.

Eine andere Möglichkeit der Realisierung des erfindungsgemäßen Solarelementes besteht darin, einen oder mehrere Hochkonverter zwischen lumineszenten Elementen oder von lumineszenten Elementen umgeben anzuordnen. In diesem Fall grenzen die Hochkonverter mit jeweils einer Seitenfläche an die Solarzelle, während sie mit den dazu nicht parallelen, vorzugsweise senkrechten, Seitenflächen, über jeweils eine erste selektiv reflektierende Schicht an die lumineszenten Elemente grenzen. Die lumineszenten Elemente sind dann vorzugsweise auf den der Solarzelle zugewandten Seiten mit zweiten reflektierenden Strukturen versehen und auf jenen Seiten, welche weder der Solarzelle noch einem Hochkonverter zugewandt sind, mit Spiegeln versehen.

Wiederum kann eine Konzentration erreicht werden, wenn jene der einfallenden Strahlung, d. h. der Solarzelle, zugewandten Flächen der lumineszenten Elemente insgesamt größer sind als die an die Hochkonverter grenzenden Flächen.

Sowohl für die Hochkonverter als auch für die lumineszenten Elemente eignen sich besonders Quader, Würfel, Zylinder und ähnliche regelgeometrische Objekte. Besonders geeignet sind quaderförmige Strukturen mit aufeinander senkrecht stehenden Seitenflächen.

Der Hochkonverter weist vorzugsweise mit Erbium dotiertes Natrium-Yttrium-Fluorid (NaYF₄:Er³⁺) auf oder besteht daraus.

Außerdem bieten sich als Hochkonverter anorganische Kristalle (als bulk, mikro- oder nanokristallines Material) wie z.B. Al₂O₃, NaYF₄ , Er(PO₃)₃, Lu(PO₃), Lu(PO₃)₃, Y(PO₃)₃, Gd(PO₃)₃, dotiert mit seltenen Erdern, wie z.B. Erbium, Ytterbium, Dysprosium oder Übergangsmetallen oder kodotiert, z.B. mit Erbium und Ytterbium oder Übergangsmetallen und Seltenen Erden, an.

Als Farbstoffe für das lumineszente Element können Cyanin, Polymethine, Wurster- und Weitz-Typ Radikale, Polymethin Violene, Monoquinon Anionen, Tetrathiotetracene, Selten-Erd dotierte Kristalle oder metallorganische Verbindungen, Übergangsmetallverbindungen, Quantum-Dots, z.B. aus PbSe, PbS (auch in sog. Core-Shell-Konfigurationen) verwendet werden.

Eingebettet werde diese in PMMA, Polycarbonat, anderen hochtransparenten Polymeren, Glas oder Glaskeramiken.

Im Folgenden soll die Erfindung anhand einiger Beispiele erläutert werden.

Es zeigt
Fig. 1 eine erste Ausführungsform des erfindungsgemäßen Solarelementes und
Fig. 2 eine zweite Ausführungsform des erfindungsgemäßen Solarelementes.

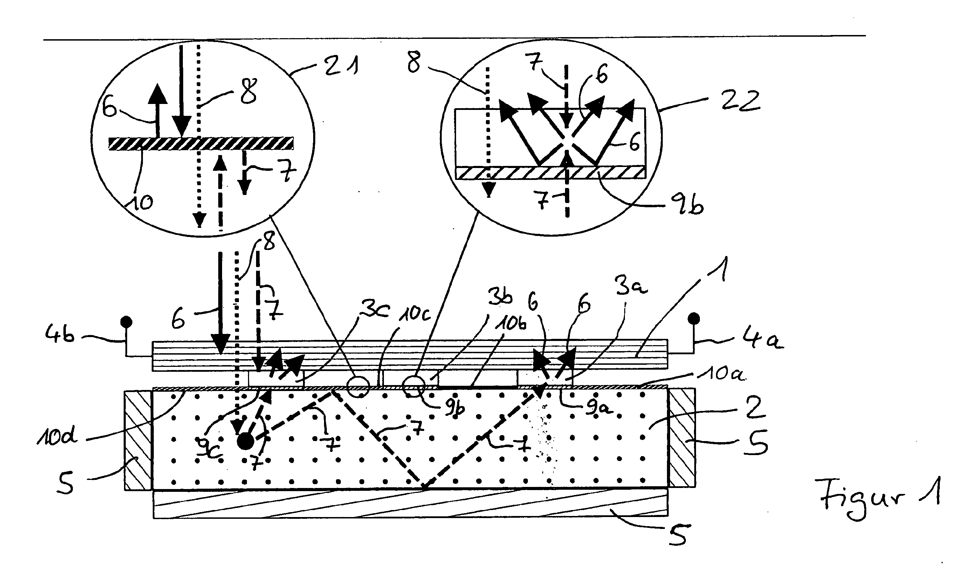

Fig. 1 zeigt eine mögliche Ausgestaltung der vorliegenden Erfindung. Hierbei ist ein quaderförmiges lumineszentes Element 2 an fünf Seiten mit Spiegeln 5 versehen. Eine Solarzelle ist neben der sechsten, nicht mit Spiegeln 5 versehenen Seite des lumineszenten Elementes 2 mit zu dieser Seite paralleler Ebene angeordnet. Zwischen der Solarzelle 1 und der nicht mit Spiegeln versehenen Seite des lumineszenten Materials 2 sind Hochkonverter 3a, 3b und 3c angeordnet. Diese Hochkonverter berühren die Solarzelle 1 direkt. Zwischen dem lumineszenten Element 2 und den Hochkonvertern 3a, 3b und 3c ist jeweils eine erste selektiv reflektierende Schicht 9a, 9b und 9c angeordnet.

Ausschnitt 22 zeigt die Durchlässigkeit der ersten selektiv reflektierenden Schicht 9b. Strahlung 6, deren Frequenz über der Band-Gap-Frequenz ν_{BG} der Solarzelle 1 liegt, wird von der selektiv reflektierenden Schicht 9b reflektiert. Strahlung 8, die vom lumineszenten Material absorbiert wird, d. h. eine Frequenz zwischen ν_{LE1} und ν_{LE2} hat, wird von der selektiv reflektierenden Struktur 9b transmittiert. Ebenso wird Strahlung 7, deren Frequenz in einem Bereich liegt, der vom Hochkonverter konvertiert werden kann, d. h. die zwischen ν_{HK1} und ν_{HK2} liegt, ebenfalls transmittiert.

In Bereichen, in denen die nicht mit einem Spiegel 5 versehene Seite des lumineszenten Elementes 2 nicht an einen Hochkonverter 3a, 3b oder 3c grenzt, ist die Oberfläche des lumineszenten Elementes 2 mit zweiten selektiv reflektierenden Strukturen 10a, 10b, 10c und 10d versehen. Diese Strukturen 10a bis 10d sind formschlüssig auf das lumineszente Material 2 aufgebracht. Vergrößerung 21 zeigt, wie Strahlung von dieser zweiten selektiv reflektierenden Struktur transmittiert bzw. reflektiert wird. Strahlung 6, die eine Frequenz größer als die Band-Gap-Frequenz ν_{BG} der Solarzelle 1 hat, wird von der selektiv reflektierenden Schicht 10a bis 10d reflektiert. Ebenso wird Strahlung 7 reflektiert, die eine Frequenz hat, die vom Hochkonverter 3a, 3b oder 3c konvertiert werden kann. Strahlung 8 hingegen, deren Frequenz zwischen ν_{LE1} und ν_{BG} liegt, d. h. die vom lumineszenten Material absorbiert werden kann aber nicht vom Hochkonverter konvertiert werden kann, wird von der selektiv reflektierenden Schicht 10a bis 10d transmittiert.

Über Anschlüsse 4a und 4b ist die Solarzelle elektrisch verschaltet.

Trifft nun von der Solarzelle nutzbare Strahlung 6 auf die Solarzelle 1, so wird diese absorbiert. Strahlung 8, deren Frequenz unterhalb der Band-Gap-Frequenz ν_{BG} der Solarzelle 1 liegt, wird von der Solarzelle 1 transmittiert und trifft auf das lumineszente Material 2. Das lumineszente Material 2 emittiert daraufhin Licht 7 mit einer Frequenz, die vom Hochkonverter 3a, 3b oder 3c konvertiert werden kann. Trifft diese Strahlung 7 auf die zweite selektiv reflektierende Struktur, so wird sie in das lumineszente Material 2 zurückreflektiert. Trifft sie hingegen auf die erste selektiv reflektierende Struktur 9a, 9b oder 9c, so wird sie in den Hochkonverter 3a, 3b oder 3c transmittiert. In diesem Hochkonverter 3a, 3b oder 3c wird sie dann in Strahlung 6 mit einer Frequenz größer als ν_{BG} konvertiert, welche dann in die Solarzelle 1 gestrahlt wird. Die Summe der Flächen des lumineszenten Elementes, die der Solarzelle 1 zugewandt sind, aber nicht durch einen Hochkonverter 3a, 3b oder 3c abgedeckt werden, und der Flächen der Hochkonverter 3a, 3b und 3c, die der Solarzelle zugewandt sind, ist größer als die Fläche der ersten selektiv reflektierenden Strukturen 9a, 9b und 9c zusammen. Dadurch wird die Effizienz der Hochkonverter gesteigert.

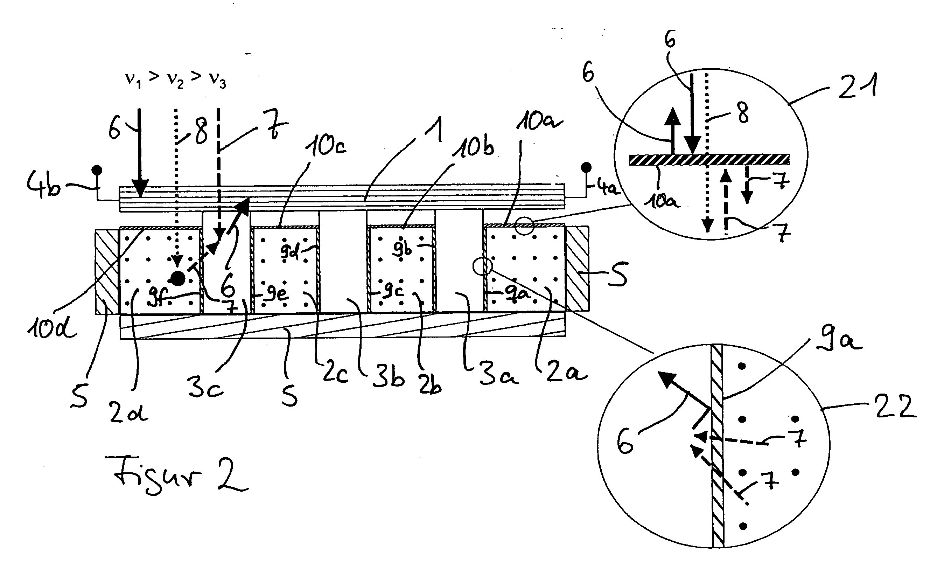

Fig. 2 zeigt eine andere Ausführungsform der vorliegenden Erfindung. Umgeben von fünf senkrecht aufeinander angeordneten Spiegeln 5 sind hier quaderförmige lumineszente Elemente 2a, 2b, 2c und 2d sowie quaderförmige Hochkonverter 3a, 3b und 3c angeordnet. Die Hochkonverter 3a bis 3c liegen hierbei zwischen den lumineszenten Elementen 2a bis 2d. Die Seitenflächen der Hochkonverter 3a bis 3c und der lumineszenten Elemente 2a bis 2d sind parallel zueinander und parallel zu den senkrecht zur Solarzelle stehenden Spiegeln 5. Zwischen je zwei lumineszenten Elementen 2a, 2b, 2c bzw. 2d ist jeweils ein Hochkonverter 3a, 3b bzw. 3c angeordnet. Parallel zu der Ebene, in welcher die lumineszenten Elemente und die Hochkonverter nebeneinander angeordnet sind, ist eine Solarzelle 1 angeordnet, welche jene Seite des jeweiligen Hochkonverters berührt, welche nicht mit einem lumineszenten Element oder einem Spiegel 5 in Kontakt ist. Diese Solarzelle 1 ist wiederum durch Kontakte 4a, 4b elektrisch verschaltet.

Trifft nun Strahlung 6 auf die Solarzelle 1, deren Frequenz höher ist als die Band-Gap-Frequenz ν_{BG} der Solarzelle 1, so wird diese von der Solarzelle absorbiert. Strahlung 8 hingegen, deren Frequenz unterhalb der Band-Gap-Frequenz ν_{BG} der Solarzelle 1 liegt, wird von dieser transmittiert und trifft auf ein lumineszentes Element 2a bis 2d. Dieses emittiert daraufhin Strahlung 7, die durch eine erste selektiv reflektierende Schicht 9a bis 9f hindurch auf einen Hochkonverter 3a bis 3c trifft. Dieser konvertiert die Strahlung 7 in Strahlung 6, deren Frequenz oberhalb der Band-Gap-Frequenz der Solarzelle liegt und daher von dieser in elektrische Energie umgewandelt werden kann. Jene Seite der lumineszenten Elemente 2a bis 2d, welche weder an einen Spiegel noch über eine erste selektiv reflektierende Struktur an einen Hochkonverter grenzt, ist mit einer zweiten selektiv reflektierenden Schicht 10a, 10b, 10c bzw. 10d beschichtet.

Die Durchlässigkeiten der ersten selektiv reflektierenden Schicht ist wiederum in Vergrößerung 22 gezeigt. Die Durchlässigkeit der zweiten selektiv reflektierenden Schicht ist in Vergrößerung 21 gezeigt. Die Funktionen dieser selektiv reflektierenden Schichten 9a und 10a entsprechen jenen in Fig. 1.

## Patentansprüche

1. Solarelement mit zumindest einer Solarzelle (1), die eine Band-Gap-Frequenz ν_{BG} hat,
zumindest einem lumineszenten Element (2), welches elektromagnetische Strahlung mit Frequenzen zwischen zwei Frequenzen ν_{LE1} und ν_{LE2} ≥ ν_{LE1} absorbiert und elektromagnetische Strahlung mit zumindest einer Frequenz ν_{LE3} emittiert, zumindest einem Hochkonverter (3a, 3b, 3c), der elektromagnetische Strahlung mit Frequenzen zwischen zwei Frequenzen ν_{HK1} und ν_{VHK2} ≥ ν_{HK1} absorbiert und Strahlung mit zumindest einer Frequenz ν_{HK3} emittiert, sowie
zumindest einer ersten selektiv reflektierenden Struktur (9a, 9b, 9c), die einen Teil der auftreffenden elektromagnetischen Strahlung reflektiert und einen Teil der auftreffenden Strahlung transmittiert,
wobei ν_{LE1} kleiner ist als ν_{BG},
für zumindest eine der zumindest einen Frequenzen ν_{LE3} gilt ν_{HK1} ≤ ν_{LE3} ≤ ν_{HK2}, und
für zumindest eine der zumindest einen Frequenzen ν_{HK3} gilt ν_{HK3} ≥ ν_{BG},
**dadurch gekennzeichnet, dass** die zumindest einen luminiszenten Elemente benachbart zu jeweils zumindest einer der ersten selektiv reflektierenden Strukturen angeordnet sind und die zumindest einen ersten selektiv reflektierenden Strukturen benachbart zu jeweils zumindest einem der mindestens einen Hochkonverter angeordnet sind und der zumindest.
eine Hochkonverter benachbart zur Solarzelle angeordnet ist.

2. Solarelement nach dem vorhergehenden Anspruch, **dadurch gekennzeichnet, dass** die Hochkonverter zumindest eine einem lumineszenten Element zugewandte Fläche als Teil ihrer Oberfläche aufweisen und die erste selektive reflektierende Struktur diese Fläche vollständig bedeckt.

3. Solarzellenelement nach einem der vorhergehenden Ansprüche, **gekennzeichnet durch** zumindest einen Spiegel (5), der benachbart oder angrenzend zum zumindest einen lumineszenten Element (2) mit zu dessen Oberfläche paralleler Spiegelebene angeordnet ist.

4. Solarelement nach dem vorhergehenden Anspruch, **dadurch gekennzeichnet, dass** die ersten selektiv reflektierenden Strukturen (9a, 9b, 9c) elektromagnetische Strahlung mit Frequenzen ≥ ν_{BG} reflektieren und elektromagnetische Strahlung mit Frequenzen zwischen ν_{HR1} und ν_{BG} transmittieren.

5. Solarelement nach einem der vorhergehenden Ansprüche, **dadurch gekennzeichnet, dass** zumindest ein lumineszentes Element (2) unmittelbar angrenzend an eine erste selektiv reflektierende Struktur (9a, 9b, 9c) angeordnet ist und/oder zumindest eine erste selektiv reflektierende Struktur unmittelbar angrenzend an zumindest einen Hochkonverter angeordnet ist und/oder zumindest ein Hochkonverter unmittelbar angrenzend an eine Solarzelle angeordnet ist.

6. Solarelement nach einem der vorhergehenden Ansprüche, **dadurch gekennzeichnet, dass** auf zumindest einem Teil der Oberfläche der zumindest einen lumineszenten Elemente eine zweite selektiv reflektierende Struktur (10a, 10b, 10c, 10d) angeordnet ist, die zur Solarzelle (1) benachbart ist und einen Teil der auf sie auftreffenden Strahlung reflektiert und einen Teil der auf sie auftreffenden Strahlung transmittiert.

7. Solarelement nach dem vorhergehenden Anspruch, **dadurch gekennzeichnet, dass** die zumindest einen lumineszenten Elemente (2) zumindest eine der Solarzelle (1) zugewandte Fläche als Teil ihrer Oberfläche aufweisen und die zweite selektiv reflektierende Struktur diese Fläche vollständig überall dort bedeckt, wo keine erste selektiv reflektierende Struktur (9a, 9b, 9c) oder Hochkonverter (3a, 3b, 3c) angeordnet sind.

8. Solarelement nach einem der beiden vorhergehenden Ansprüche, **dadurch gekennzeichnet, dass** die zweite selektiv reflektierende Struktur (10a, 10b, 10c, 10d) elektromagnetische Strahlung mit der zumindest einen Frequenz ν_{LE3} reflektiert sowie elektromagnetische Strahlung mit Frequenzen zwischen ν_{LE1} und ν_{BG} transmittiert.

9. Solarelement nach einem der Ansprüche 6 bis 8, **dadurch gekennzeichnet, dass** die Summe jenes Teils der Oberfläche der Hochkonverter, der der. Solarzelle zugewandt ist und jenes Teils der Oberfläche der lumineszenten Elemente, der der Solarzelle, aber nicht einem Hochkonverter zugewandt ist, größer ist als die Summe der Flächenbereiche mit denen die Hochkonverter den lumineszenten Elementen zugewandt sind.

10. Solarelement nach einem der Ansprüche 6 bis 9, **dadurch gekennzeichnet, dass** die Gesamtfläche der zweiten selektiv reflektierenden Strukturen größer ist als die Gesamtfläche der ersten selektiv reflektierenden Strukturen.

11. Solarelement nach einem der Ansprüche 6 bis 10, **dadurch gekennzeichnet, dass** jener der Solarzelle zugewandte Teil der Oberflächen der lumineszenten Elemente größer ist, als jener den Hochkonvertern zugewandte Teil der Oberflächen der lumineszenten Elemente.

12. Solarelement nach einem der Ansprüche 3 bis 11, **dadurch gekennzeichnet, dass** Spiegel (5) an jeder Oberfläche der lumineszenten Elemente angeordnet sind, an der keine selektiv reflektierende Struktur angeordnet ist.

13. Solarelement nach einem der vorhergehenden Ansprüche, **dadurch gekennzeichnet, dass** zumindest einer der zumindest einen Hochkonverter (3a, 3b, 3c) zwischen einem lumineszenten Element (2) und einer Solarzelle (1) angeordnet ist.

14. Solarelement nach einem der vorhergehenden Ansprüche, **dadurch gekennzeichnet, dass** zumindest einer der zumindest einen Hochkonverter (3a, 3b, 3c) zwischen zumindest zwei lumineszenten Elementen (2) angeordnet ist, wobei der Hochkonverter zumindest eine Fläche aufweist, mit welcher er an die Solarzelle (1) grenzt.

15. Solarelement nach einem der vorhergehenden Ansprüche, **dadurch gekennzeichnet, dass** der Hochkonverter (3a, 3b, 3c) mit Erbium dotiertes Natrium-Yttrium-Fluorid oder NaYF₄:Er³⁺ aufweist oder daraus besteht.

16. Verfahren zur Effizienzsteigerung einer solarzelle, welche eine Band-Gap-Frequenz ν_{BG} hat, wobei Licht mit einer Frequenz kleiner als ν_{BG} auf zumindest ein lumineszentes Element geleitet wird, welches Licht emittiert,
**dadurch gekennzeichnet, dass** lumineszenten Element emittierte Licht auf zumindest einen Hochkonverter geleitet wird, der Licht mit einer Frequenz größer oder gleich ν_{BG} emittiert, **dadurch gekennzeichnet, dass** das von dem zumindest einen lumineszenten Element emittierte Licht durch eine erste selektiv reflektierende Struktur geleitet wird, die Licht mit einer Frequenz größer als ν_{BG} reflektiert.

17. Verfahren nach dem vorhergehenden Anspruch, **dadurch gekennzeichnet, dass** ein Solarelement nach einem der Ansprüche 1 bis 15 verwendet wird.

## Claims

1. Solar element having at least one solar cell (1) which has a band gap frequency ν_{BG},
at least one luminescent element (2) which absorbs electromagnetic radiation with frequencies between two frequencies ν_{LE1} and ν_{LE2} ≥ ν_{LE1} and emits electromagnetic radiation with at least a frequency ν_{LE3},
at least one upconverter (3a, 3b, 3c) which absorbs electromagnetic radiation with frequencies between two frequencies ν_{HK1} and ν_{HK2} ≥ ν_{HK1} and emits radiation with at least a frequency ν_{HK3}, and also
at least one first selectively reflecting structure (9a, 9b, 9c) which reflects a part of the incident electromagnetic radiation and transmits a part of the incident radiation,
wherein ν_{LE1} is smaller than ν_{BG},
there applies for at least one of the at least one frequencies ν_{LE3}, ν_{HK1} ≤ ν_{LE3} ≤ ν_{HK2}, and
there applies for at least one of the at least one frequencies ν_{HK3}, ν_{HK3} ≥ ν_{BG},
**characterised in that** the at least one luminescent elements are disposed adjacent to respectively at least one of the first selectively reflecting structures and the at least one first selectively reflecting structures are disposed adjacent to respectively at least one of the at least one upconverters and the at least one upconverter is disposed adjacent to the solar cell.

2. Solar element according to the preceding claim, **characterised in that** the upconverters have at least one area as part of their surface, orientated towards a luminescent element, and the first selective reflecting structure completely covers this surface.

3. Solar cell element according to one of the preceding claims, **characterised by** at least one mirror (5) which is disposed adjacently or abutting relative to the at least one luminescent element (2) with the mirror plane parallel to the surface thereof.

4. Solar element according to the preceding claim, **characterised in that** the first selectively reflecting structures (9a, 9b, 9c) reflect electromagnetic radiation with frequencies ≥ ν_{BG} and transmit electromagnetic radiation with frequencies between ν_{HK1} and ν_{BG}.

5. Solar element according to one of the preceding claims, **characterised in that** at least one luminescent element (2) is disposed directly abutting against a first selectively reflecting structure (9a, 9b, 9c) and/or at least one first selectively reflecting structure is disposed directly abutting against at least one upconverter and/or at least one upconverter is disposed directly abutting against a solar cell.

6. Solar element according to one of the preceding claims, **characterised in that** a second selectively reflecting structure (10a, 10b, 10c, 10d) is disposed on at least a part of the surface of the at least one luminescent elements, which second selectively reflecting structure is adjacent to the solar cell (1) and reflects a part of the radiation impinging thereon and transmits a part of the radiation impinging thereon.

7. Solar element according to the preceding claim, **characterised in that** the at least one luminescent elements (2) as part of their surface have an area, orientated towards the solar cell (1), and the second selectively reflecting structure completely covers this surface wherever no first selectively reflecting structure (9a, 9b, 9c) or upconverter (3a, 3b, 3c) are disposed.

8. Solar element according to one of the two preceding claims, **characterised in that** the second selectively reflecting structure (10a, 10b, 10c, 10d) reflects electromagnetic radiation with the at least one frequency ν_{LE3} and also transmits electromagnetic radiation with frequencies between ν_{LE1} and ν_{BG}.

9. Solar element according to one of the claims 6 to 8, **characterised in that** sum of that part of the surface area of the upconverters which is orientated towards the solar cell and that part of the surface area of the luminescent elements which is orientated towards the solar cell but not towards an upconverter is greater than the sum of the surface regions with which the upconverters are orientated towards the luminescent elements.

10. Solar element according to one of the claims 6 to 9, **characterised in that** the total surface area of the second selectively reflecting structures is greater than the total surface area of the first selectively reflecting structures.

11. Solar element according to one of the claims 6 to 10, **characterised in that** that part of the surface areas of the luminescent elements, orientated towards the solar cell, is greater than that part of the surface areas of the luminescent elements orientated towards the upconverters.

12. Solar element according to one of the claims 3 to 11, **characterised in that** mirrors (5) are disposed on each surface of the luminescent elements, on which surface no selectively reflecting structure is disposed.

13. Solar element according to one of the preceding claims, **characterised in that** at least one of the at least one upconverters (3a, 3b, 3c) is disposed between a luminescent element (2) and a solar cell (1).

14. Solar element according to one of the preceding claims, **characterised in that** at least one of the at least one upconverters (3a, 3b, 3c) is disposed between at least two luminescent elements (2), the upconverter having at least one area with which it abuts against the solar cell (1).

15. Solar element according to one of the preceding claims, **characterised in that** the upconverter (3a, 3b, 3c) has or comprises sodium yttrium fluoride or NaYF₄ : Er³⁺ doped with erbium.

16. Method for increasing the efficiency of a solar cell which has a band gap frequency ν_{BG}, wherein light with a frequency less than ν_{BG} is conducted onto at least one luminescent element which emits light,
**characterised in that** the light emitted by at least one luminescent element is conducted onto at least one upconverter which emits light with a frequency greater than or equal to ν_{BG}, **characterised in that** light emitted by the at least one luminescent element is conducted through a first selectively reflecting structure which reflects light with a frequency greater than ν_{BG}.

17. Method according to the preceding claim, **characterised in that** a solar element according to one of the claims 1 to 15 is used.

## Revendications

1. Elément solaire avec au moins une cellule solaire (1), qui a une fréquence de bande interdite ν_{BG},
au moins un élément luminescent (2) qui absorbe un rayonnement électromagnétique de fréquences comprises entre deux fréquences ν_{LE1} et ν_{LE2} ≥ ν_{LE1} et émet un rayonnement électromagnétique d'au moins une fréquence VLE3,
au moins un convertisseur élévateur (3a, 3b, 3c), qui absorbe un rayonnement électromagnétique de fréquences comprises entre deux fréquences ν_{HK1} et ν_{HK2} ≥ ν_{HK1} et émet un rayonnement d'au moins une fréquence ν_{HK3}, et
au moins une première structure à réflexion sélective (9a, 9b, 9c) qui réfléchit une partie du rayonnement électromagnétique incident et transmet une partie du rayonnement incident,
dans lequel ν_{LE1} est inférieur à ν_{BG}
pour au moins une des au moins une fréquences ν_{LE3}, on peut écrire ν_{HK1} ≤ ν_{LE3} ≤ ν_{HK2} et, pour au moins une des au moins une fréquences ν_{HK3}, on peut écrire ν_{HK3} ≥ ν_{BG},
**caractérisé en ce que** les au moins un éléments luminescents sont adjacents à respectivement au moins l'une des premières structures à réflexion sélective, les au moins une premières structures à réflexion sélective sont adjacentes à respectivement au moins l'un des au moins un convertisseurs élévateurs et le au moins un convertisseur élévateur est adjacent à la pile solaire.

2. Elément solaire selon la revendication précédente, **caractérisé en ce que** les convertisseurs élévateurs présentent au moins une zone de leur surface tournée vers un élément luminescent et la première structure à réflexion sélective couvre complètement cette zone.

3. Elément de cellule solaire selon l'une quelconque des revendications précédentes, **caractérisé par** au moins un miroir (5) qui est adjacent ou attenant à au moins un élément luminescent (2) avec le plan du miroir parallèle à la surface de l'élément luminescent.

4. Elément solaire selon la revendication précédente, **caractérisé en ce que** les premières structures à réflexion sélective (9a, 9b, 9c) réfléchissent un rayonnement électromagnétique de fréquences ≥ ν_{BG} et transmettent un rayonnement électromagnétique de fréquences comprises entre ν_{HK1} et ν_{BG}.

5. Elément solaire selon l'une quelconque des revendications précédentes, **caractérisé en ce qu'**au moins un élément luminescent (2) est directement attenant à une première structure à réflexion sélective (9a, 9b, 9c) et/ou au moins une première structure à réflexion sélective est directement attenante à au moins un convertisseur élévateur et/ou au moins un convertisseur élévateur est directement attenant à une cellule solaire.

6. Elément solaire selon l'une quelconque des revendications précédentes, **caractérisé en ce qu'**il est agencé sur au moins une partie de la surface des au moins un éléments luminescents une seconde structure à réflexion sélective (10a, 10b, 10c, 10d) qui est adjacente à la cellule solaire, qui réfléchit une partie du rayonnement qui la frappe et qui transmet une partie du rayonnement qui la frappe.

7. Elément solaire selon la revendication précédente, **caractérisé en ce que** les au moins un éléments luminescents (2) présentent au moins une zone de leur surface tournée vers la cellule solaire (1) et la seconde structure à réflexion sélective couvre cette zone complètement partout où il n'y a aucune première structure à réflexion sélective (9a, 9b, 9c) ni aucun convertisseur élévateur (3a, 3b, 3c).

8. Elément solaire selon l'une quelconque des deux revendications précédentes, **caractérisé en ce que** la seconde structure à réflexion sélective (10a, 10b 10c, 10d) réfléchit un rayonnement électromagnétique de la au moins une fréquence ν_{LE3} et transmet un rayonnement électromagnétique de fréquences comprises entre ν_{LE1} et ν_{BG}.

9. Elément solaire selon l'une quelconque des revendications 6 à 8, **caractérisé en ce que** la somme de la zone de la surface des convertisseurs élévateurs, qui est tournée vers la cellule solaire, et de la partie de la surface des éléments luminescents, qui est tournée vers la cellule solaire, mais pas vers le convertisseur élévateur, est supérieure à la somme des zones de surface par lesquelles les convertisseurs élévateurs sont tournés vers les éléments luminescents.

10. Elément solaire selon l'une quelconque des revendications 6 à 9, **caractérisé en ce que** la surface totale des secondes structures à réflexion sélective est supérieure à la surface totale des premières structures à réflexion sélective.

11. Elément solaire selon l'une quelconque des revendications 6 à 10, **caractérisé en ce que** la partie des surfaces des éléments luminescents tournée vers la cellule solaire est supérieure à la partie des surfaces des éléments luminescents tournée vers les convertisseurs élévateurs.

12. Elément solaire selon l'une quelconque des revendications 3 à 11, **caractérisé en ce que** des miroirs (5) sont agencés sur chaque surface des éléments luminescents, sur laquelle aucune structure à réflexion sélective n'est disposée.

13. Elément solaire selon l'une quelconque des revendications précédentes, **caractérisé en ce qu'**au moins l'un des au moins un convertisseurs élévateurs (3a, 3b, 3c) est agencé entre un élément luminescent (2) et une cellule solaire (1).

14. Elément solaire selon l'une quelconque des revendications précédentes, **caractérisé en ce qu'**au moins l'un des au moins un convertisseurs élévateurs (3a, 3b, 3c) est agencé entre au moins deux éléments luminescents (2), le convertisseur élévateur présentant au moins une zone de surface par laquelle il est attenant à la cellule solaire (1).

15. Elément solaire selon l'une quelconque des revendications précédentes, **caractérisé en ce que** le convertisseur élévateur (3a, 3b, 3c) comporte du fluorure de sodium-yttrium dopé à l'erbium ou du NaYF₄:Er³⁺ ou en est constitué.

16. Procédé d'accroissement de l'efficacité d'une cellule solaire, qui a une fréquence de largeur de bande interdite ν_{BG}, dans lequel de la lumière d'une fréquence inférieure à ν_{BG} est dirigée sur au moins un élément luminescent, qui émet de la lumière,
**caractérisé en ce que** la lumière émise par au moins un élément luminescent est dirigée sur au moins un convertisseur élévateur, qui émet de la lumière d'une fréquence supérieure ou égale à ν_{BG} et **caractérisé en ce que** la lumière émise par le au moins un élément luminescent est conduite à travers une première structure à réflexion sélective, qui réfléchit la lumière à une fréquence supérieure à ν_{BG}.

17. Procédé selon la revendication précédente, **caractérisé en ce que** l'on utilise un élément solaire selon l'une quelconque des revendications 1 à 15.
